# EUROPEAN PATENT SPECIFICATION

(11) **EP 1 659 843 B1**
(45) Date of publication and mention of the grant of the patent: **30.01.2008**
(21) Application number: 05110147.5
(22) Date of filing: 28.10.2005
(51) Int. Cl.: H05K 7/20

(54) **Fans and fan frames**
Ventilator und seine Trägerstruktur
Ventilateur et son cadre de support

(30) Priority: 19.11.2004 CN 200410095300
(43) Date of publication of application: 24.05.2006
(73) Proprietor: Delta Electronics, Inc., Taoyuan Hsien 333 (TW)
(72) Inventor: Lu, Lobato, 333, Taoyuan Hsien (TW); Wang, Ke-Nan, 333, Taoyuan Hsien (TW); Huang, Wen-Shi, 333, Tayouan Hsien (TW)
(74) Representative: Patentanwälte Kewitz & Kollegen

(56) References cited:
- DE-U1- 29 921 448
- US-A- 4 517 880

## Description

### BACKGROUND

The invention relates to fans and fan frames, and in particular to fans and fan frames capable of reducing noise.

AS performance of electronic devices is promoted, heat dissipation apparatus or systems are indispensable and are thus provided in the electronic devices. If heat generated by an electronic device cannot be efficiently dissipated, performance of the electronic device may deteriorate or the electronic device may be damaged. A heat dissipation apparatus thus plays an important role in removing heat generated by electronic devices such as integrated circuits (ICs). With promotion of package techniques, the area of integrated circuits decreases. Heat accumulated in the integrated circuit per unit area increases accordingly. Therefore, a heat dissipation apparatus with high heat-dissipating efficiency is required on the integrated circuit.

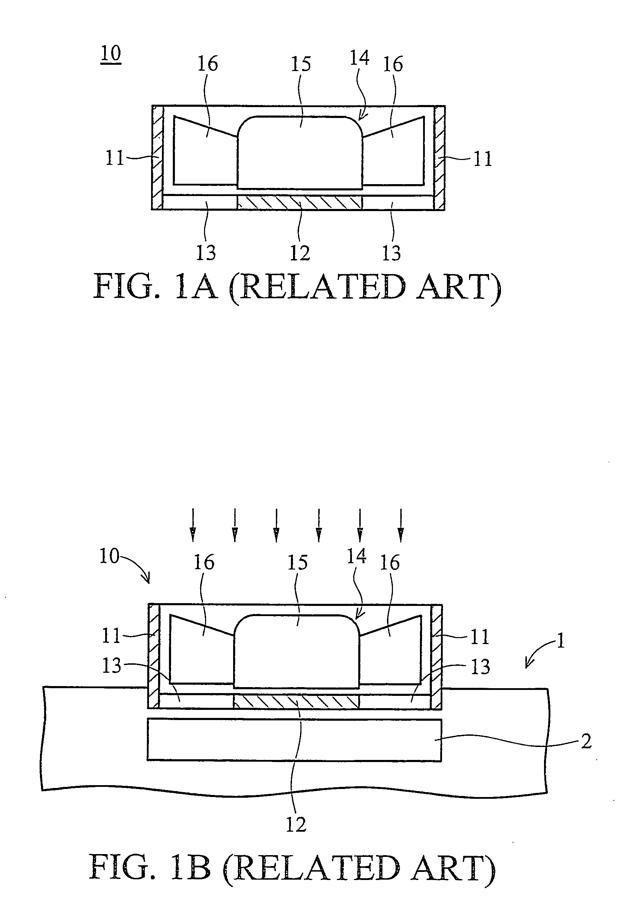

Fans are widely used in various heat-generating systems. FIG. 1A is a schematic cross section of a conventional fan, and FIG. 1B is a schematic view showing the fan of FIG. 1A applied to an exterior system 1. A conventional fan 10 includes a frame 11, an impeller 14, and a motor (not shown). The impeller 14 further includes a hub 15 and multiple blades 16 radially connected to the hub 15. The motor is disposed inside of the hub 15.

The impeller 14 and motor are in the frame 11, and the impeller 14 is driven by the motor to rotate. The motor base 12 is connected to the frame 11 by a plurality of ribs 13 and the ribs support the motor base 12.

As shown in FIG. 1B, when the fan 10 is applied to a heat-generating exterior system 1, the motor base 12 locates on the same plane as the frame 11 such that space required by outtake airflow is limited, the amount of airflow cannot be increased and noise generated by the fan 10 cannot be reduced. Moreover, the fan 10 is fixed on and combined to a heat-generating device 2 in the exterior system 1 by screws penetrating the frame 11. During the operation of the fan 10, vibrations generated by the motor and rotation of the impeller 14 are transferred to the heat-generating device 2 and the exterior system 1 via the motor base 12 and ribs 13, thereby generating noise. Also, vibrations generated by the motor may damage the heat-generating device 2 or other components in the exterior system 1.

German Utility Model 299 21 448 U1 discloses a fan for an apparatus housing. The fan comprises a housing having straight cylindrical peripheral wall, which forms a passage for the air flow. A motor base of the fan is disposed at within the passage. The peripheral wall of the housing is axially extended so that the motor based does not lie within a plane spanned by the air inlet or air outlet of the passage. Thus, the space required by outtake airflow is limited, the amount of airflow cannot be increased and noise generated by the fan cannot be reduced.

U.S. patent 4517880 discloses a fan mounting assembly, wherein an axial flow electric fan is held by a plurality of latches and retainers at a flexible molded plastic panel closure of an electrical device, such as a TV set.

U.S. patent application 2004/0212262 A1 discloses a fan motor structure wherein the fan hub is formed with an extrusion protruding from its top planar surface and the shaft is fit into the bearing assembly and connected to the fan hub.

### SUMMARY

It is an object of the present invention to provide a fan frame and a fan so that the area of air flow intake or discharge can be increased while providing a stable airflow and reducing noise and vibrations.

This object is achieved by a fan frame according to claim 1 and by a fan according to claim 10. Further advantageous embodiments are the subject-matter of further dependent claims.

According to the present invention the motor base of the fan is raised into the housing of the fan to thereby increase the area of air flow intake or discharge and provide a stable airflow. Additionally, noise and vibrations, generated by rotation of an impeller and transferred to an exterior system via the motor base during the operation of the fan, can be reduced according to the present invention.

An exemplary embodiment of the invention provides a fan frame including a housing and a motor base. The housing has a passage, and the passage forms an air outlet and an air inlet on both ends of the housing. The motor base is disposed in the housing. When the motor base is at the air outlet or the air inlet, the bottom of the motor base locates on a plane different from that of the air outlet or the air inlet. The fan frame further includes a plurality of ribs connected between the housing and the motor base to support the motor base. The cross section, width or thickness of each rib is varied along the direction from the motor base to the housing. The housing further includes an outward expansion portion at the air outlet or the air inlet to increase the area of air flow intake or discharge. The motor base has a slope inclined radially to adjust the area of air flow intake or discharge, and the slope is linear or curved. Moreover, the motor base is a part of a system having a fan assembly. The system is preferably a power supply, a server, or a computer. The motor base forms a casing sidewall of a system, such as a fan guard.

Another exemplary embodiment of the invention provides a fan, such as an axial flow fan, including a fan frame and an impeller. The fan frame has a housing and a motor base. The housing has a passage, and the passage forms an air outlet and an air inlet on both ends of the housing. The motor base is disposed in the housing, and the impeller is disposed on the motor base. When the motor base is at the air outlet or the air inlet, the bottom of the motor base locates on a plane different from that of the air outlet or the air inlet. The fan frame further includes a plurality of ribs disposed between the housing and the motor base to support the motor base. The cross section, width or thickness of each rib is varied along the direction from the motor base to the housing. The housing further includes an outward expansion portion at the air outlet or the air inlet to increase the area through which the air flows into and out of the housing. The outward expansion portion is formed with a lead angle, a sloped angle, a lead and sloped angle, or a curved angle. The motor base has a slope inclined radially to adjust the area of air flow intake or discharge, and the slope is linear or curved.

Moreover, the fan frame is applied to a light source. The periphery of the passage is an inner surface, and the light is blocked from penetrating the passage by the inner surface when light emitted by the light source enters the passage. The outer edge of the impeller is parallel to the curved surface of the periphery of the passage. The inner surface includes one or multiple gradually shrinking surfaces and gradually expanding surfaces so as to block the light emitted by the light source. Alternatively, the inner surface includes a radially and gradually shrinking curved surface and a radially and gradually expanding curved surface, both of which have different curvatures. In addition, each blade of the impeller overlaps an adjacent blade in an axial direction of the passage. The housing is substantially rectangular, circular, elliptical, or rhombic. The motor base may be a part of a system having a fan assembly. The system is preferably a power supply, a server, or a computer. Additionally, the motor base forms a casing sidewall of a system, such as a fan guard.

A detailed description is given in the following embodiments with reference to the accompanying drawings.

### DESCRIPTION OF THE DRAWINGS

The invention can be more fully understood by reading the subsequent detailed description and examples with references made to the accompanying drawings, wherein:
FIG. 1A is a schematic cross section of a conventional fan;
FIG. 1B is a schematic view showing the fan of FIG. 1A applied to an exterior system;
FIGs. 2A-2C are schematic views of fans of an embodiment serving to ease an understanding of the present invention;
FIG. 3A is a schematic view of a fan of the first embodiment of the invention;
FIG. 3B is a schematic view showing the fan of FIG. 3A applied to an exterior system;
FIGs. 4A-4D are schematic views of fans of the second embodiment of the invention;
FIGs. 5A-5D are schematic views of fans of the third embodiment of the invention;
FIGs. 6A and 6B are schematic views of fans of the fourth embodiment of the invention; and
FIG. 6C is a schematic top view of an impeller of an embodiment of the invention.

### DETAILED DESCRIPTION

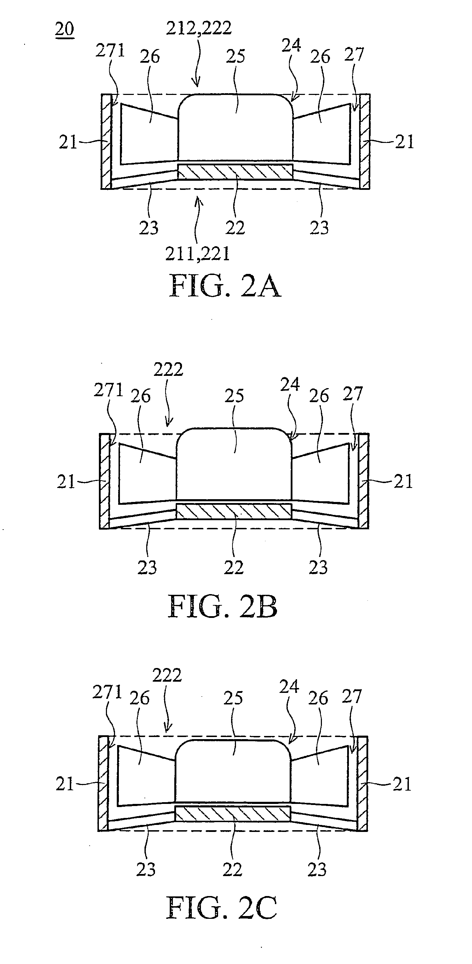

FIGs. 2A-2C are schematic views of fans 20 of an embodiment serving to ease an understanding of the present invention. As shown in FIG. 2A, the fan 20, preferably an axial flow fan, includes a fan frame 21 and an impeller 24. The fan frame 21 is a housing 21 having a passage 27, and the shape of the fan frame 21 is substantially rectangular, circular, elliptical, or rhombic. The housing 21 includes a motor base 22 and a plurality of ribs 23. The impeller 24 includes a hub 25 and multiple blades 26 connected to the hub 25, and there is a motor (not shown) disposed inside of the hub 25 for driving the impeller 24 to rotate. The impeller 24, motor base 22, and motor are disposed in the housing 21. The impeller 24 is disposed on the motor base 22 and is rotated by the motor. The ribs 23 are disposed between the periphery 271 of the passage 27 and the motor base 22, for supporting the motor base 22. The passage 27 forms an air outlet 211 and an air inlet 212 on both ends of the housing 21, and the air outlet 211 and air inlet 212 are on a first hypothetical plane 221 and a second hypothetical plane 222, respectively.

To overcome the drawbacks in which the bottom of the conventional motor base 12 is coplanar with the fan frame, the motor base 22 is raised into the housing 21 to form a displacement depth so as to provide a stable airflow. As shown in FIG. 2A, the motor base 22 is preferably disposed at the air outlet 211, and the bottom of the motor base 22 is located on a plane different from that of the air outlet 211 (first hypothetical plane 221). Alternatively, the motor base 22 can be disposed at the air inlet 212, and the bottom of the motor base 22 is located on a plane different from that of the air inlet 212 (second hypothetical plane 222).

When the motor base 22 is raised into the housing 21, the top of the hub 25 disposed on the motor base 22 protrudes the second hypothetical plane 222, as shown in FIG. 2B. However, operation and performance of the fan 20 is not adversely affected. Further, considering of the situation that the fan 20 must be disposed coordinately with other components in an exterior system when the fan 20 is applied to the exterior system, the size of the hub 25 is correspondingly adjusted. Thus, the top of the hub 25 can just be aligned with the second hypothetical plane 222 (as shown in FIG. 2A) or be slightly lower than the second hypothetical plane 222 (as shown in FIG. 2C) so that the hub 25 does not adversely affect operation of other components in the exterior system.

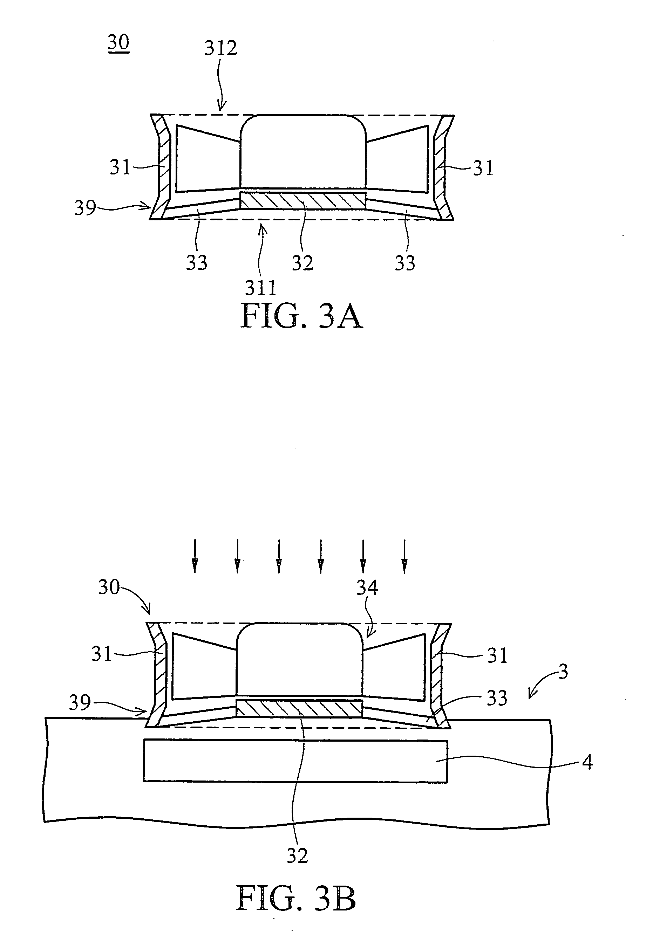

FIG. 3A is a schematic view of a fan 30 of the first embodiment of the invention. Not only the motor base 32 is raised into the housing 31 to form a displacement depth, but also there is preferably an outward expansion portion 39 formed at the air outlet 311 or the air inlet 312 to increase an area of air flow intake or discharge, thereby enhancing air pressure and airflow of the fan 30. Additionally, when the outward expansion portion 39 is disposed at the air outlet 311, deceleration and rectification of the airflow can be obtained. The outward expansion portion 39 can be formed with a lead angle, a sloped angle, a lead and sloped angle, or a curved angle. The ribs 33 can be directly connected to the outward expansion portion 39 and motor base 32, for supporting the motor base 32. Alternatively, the ribs 33 can be connected to other portions, except the outward expansion portion 39, of the housing 31.

FIG. 3B is a schematic view showing the fan 30 of FIG. 3A applied to an exterior system 3. The fan 30 is applied to the exterior system 3 having a heat-generating device 4 such as integrated circuits (ICs). Since a displacement depth exists between the bottom of the motor base 32 and the outlet of the housing 31, a space for outtake airflow is enlarged, thereby enhancing the amount of airflow of the fan 30. Additionally, the outward expansion portion 39 achieves deceleration and rectification of the airflow, thereby reducing the noise caused by turbulent flow field. Furthermore, since the bottom of the motor base 32 is higher than the outlet of the housing 31, vibrations generated by the motor and rotation of the impeller 34 will not be transferred to the heat-generating device 4 or the exterior system 3 via the motor base 32 and ribs 33. Thus, the noise problem is solved and damage to components caused by the aforementioned vibrations can be prevented.

The motor base 32 can be considered as a part of a system having a fan assembly, or the motor base 32 forms a casing sidewall of a system, such as a fan guard. The system 3 is a power supply, a server, or a computer.

The invention is not limited to the aforementioned structure. For example, in addition to the structural design of the motor base 32 and outward expansion portion 39, the thickness, width, or cross section of the ribs can be designed to various requirements.

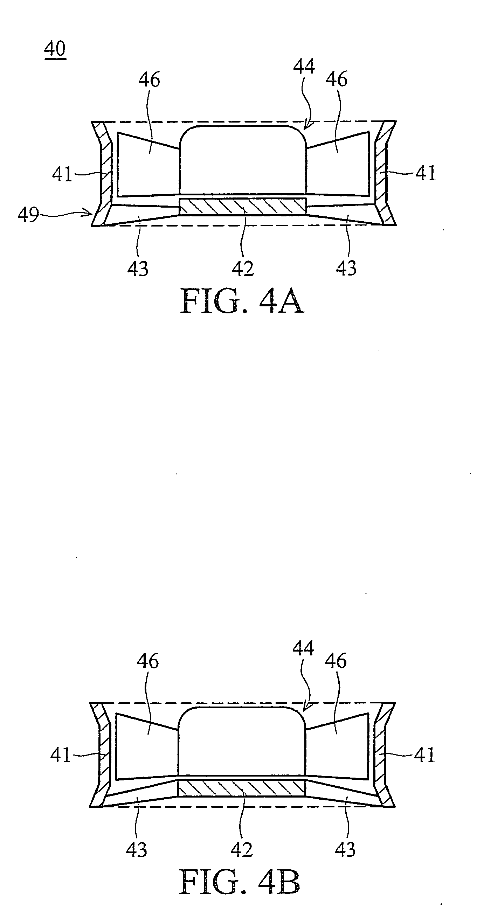

Referring to FIGs. 4A-4D, which are schematic views of fans 40 of the second embodiment of the invention. As shown in FIG. 4A, the housing 41 of fan 40 has an outward expansion portion 49, and the multiple ribs 43, connected to the outward expansion portion 49 and motor base 42, can be arranged in radial manner. The shape of ribs 43 can be, for example, columnar, curved, or streamlined.

Specifically, if the ribs 43 are connected to the motor base 42 and fan frame 41 in nonlinear manner, the cross section of the ribs 43 will not be continuous. For ease of description, the cross sections of the ribs of all embodiments of the invention are completely shown and the blades are shown in a clearer manner.

The thickness of each rib 43 is varied along the direction from the motor base 42 to the housing 41. As shown in FIG. 4A, the thickness of each rib 43 at the motor base 42 is smaller than that at the housing 11. Further, the thickness of each rib 43 gradually increases from the motor base 42 to the housing 41. The change in the thickness of each rib 43 can be linear slope gradual reduction or curve slope gradual reduction.

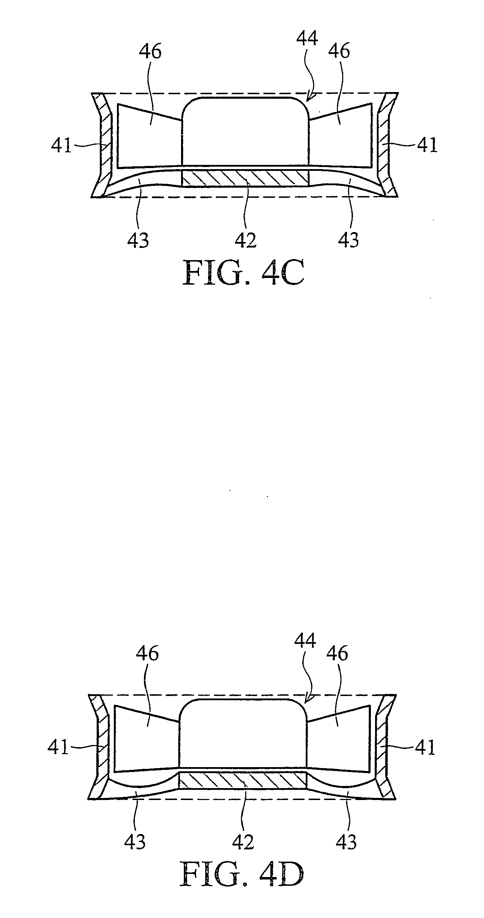

Alternatively, the thickness of each rib 43 at the motor base 42 is greater than that at the housing 41. Further, the thickness of each rib 43 gradually decreases from the motor base 42 to the housing 41, as shown in FIG. 4B. The change in the thickness of each rib 43 can be linear slope gradual reduction (as shown in FIG. 4B) or curve slope gradual reduction (as shown in FIG. 4C). Further, the thickness of each rib 43 connecting to the motor base 42 and housing 41 is relatively greater than that of a central part of the rib 43 and the thickness of each rib 43 is relatively less than that of the central part of the rib 43, as shown in FIG. 4D. Furthermore, the thickness of each rib 43 connecting to the motor base 42 and housing 41 is least.

When the impeller 44 rotates, airflow speed increases outwardly from the blades 46. Namely, the flow speed near the housing 41 is faster than the speed near the motor base 42. Additionally, varied thickness design is applied to each rib 43 so that the distances between each rib 43 and the lower edges of the blades 46 are different. In view of the direction of the airflow, the distances between the blades 46 and each rib 43 are different. Accordingly, when the impeller 44 rotates, adverse interaction between the blades 46 and the ribs 43 can be reduced. The resistance of airflow and noise can thus be reduced.

The width of each rib 43 is designed according to the rotational direction of the blades 46. The width of each rib 43 is varied along the direction from the motor base 42 to the housing 41. For example, each rib 43 at the motor base 42 is thinner than at the housing 41. Further, the width of each rib 43 gradually increases from the motor base 42 to the housing 41. The change in the width of each rib 43 can be linear slope gradual reduction or curve slope gradual reduction. In addition, the width of each rib 43 at the motor base 42 exceeds that at the housing 41. Further, the width of each rib 43 gradually decreases from the motor base 42 to the housing 41. Similarly, the change in the width of each rib 43 can be linear slope gradual reduction or curve slope gradual reduction. Alternatively, the width of each rib 43 connecting to the motor base 42 and housing 41 is relatively greater than that of a central part of the rib 43 while the central part of the rib 43 is thinnest through the rib 43. Furthermore, the width of each rib 43 connecting to the motor base 42 and housing 41 is relatively less than that of the central part of the rib 43.

When the impeller 44 rotates, airflow speed increases outwardly from the blades 46. Namely, the flow speed near the housing 41 is faster than the speed near the motor base 42. Additionally, the width of each rib 43 is varied along the direction from the motor base 42 to the housing 41. In view of the rotating direction of the blades 46, the width of each rib 43 is varied. Accordingly, the influence caused by faster airflow at the ribs 43 and housing 41 can be reduced by the aforementioned structural design. The resistance of airflow and noise can thus be reduced.

The width and thickness of each rib 43 can be changed and better designed. For example, in view of the rotating direction of the blades 46 and for each rib 43, the portion with a smaller width can have a larger thickness. Thus, the strength of the housing 41 is not adversely affected due to thin ribs 43. For example, each rib 43 at the motor base 42 is thinner than at the housing 41, and each rib 43 at the motor base 42 is thicker than at the housing 41. Alternatively, the width of each rib 43 at the motor base 42 exceeds that at the housing 41, and the thickness of each rib 43 at the motor base 42 is less than that at the housing 41. The change in the width and thickness of each rib 43 can simultaneously be linear or curved. Accordingly, the cross section of each rib 43 is varied along the direction from the motor base 42 to the housing 41, whereby preventing noise caused by the resistance of airflow between the lower edges of the blades and the ribs.

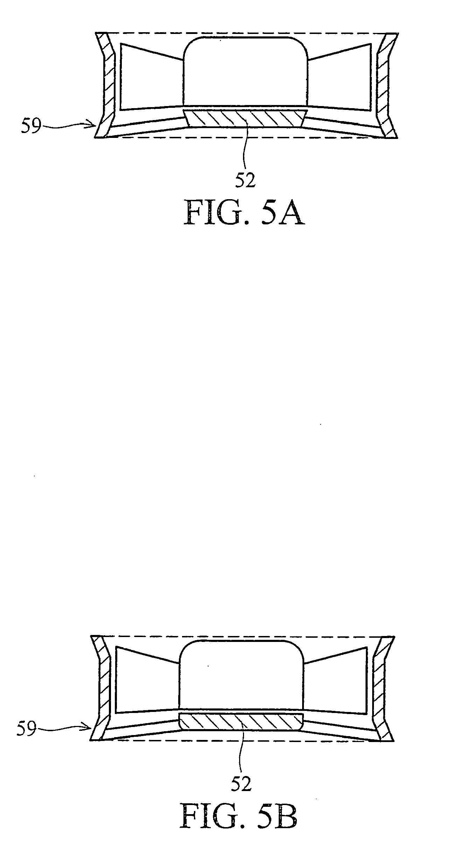

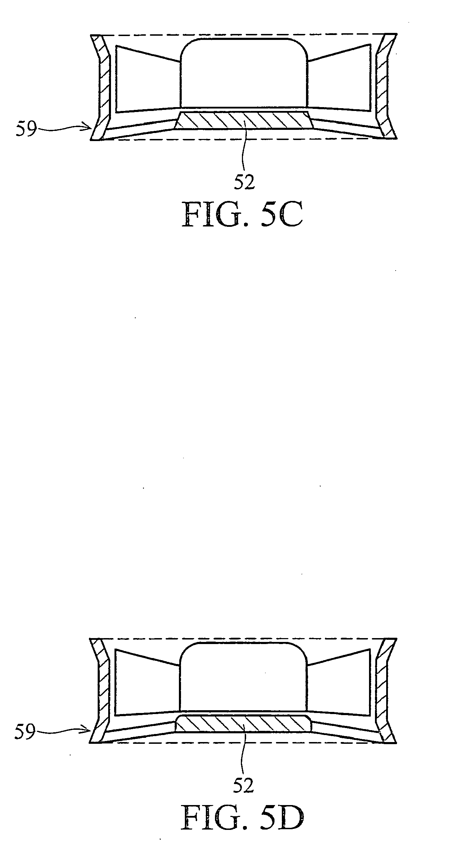

FIGs. 5A-5D are schematic views of fans of the third embodiment of the invention. The fan includes a raised motor base 52 and an outward expansion portion 59. Also, the motor base 52 includes a slope inclined radially to adjust the area of air flow intake or discharge, whereby optimizing the flow field distributed in the fan. Therefore, the noise of the fan can be further reduced and performance of the fan is enhanced. The motor base 52 expands outwardly from the bottom thereof, and the slope is linear (as shown in FIG. 5A) or curved (as shown in FIG. 5B). Alternatively, the motor base 52 inward shrinks from the bottom thereof, and the slope is linear (as shown in FIG. 5C) or curved (as shown in FIG. 5D).

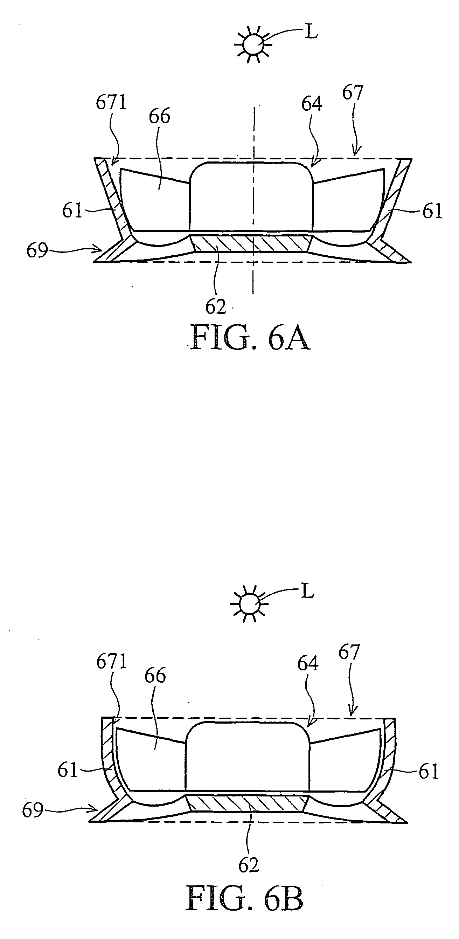

Moreover, the fan can be applied to an external system with a light source L, such as a projector. Referring to FIGs. 6A and 6B, which are schematic views of fans of the fourth embodiment of the invention. Similarly, the fan includes a raised motor base 62 and an outward expansion portion 69. Additionally, in the housing 61, the periphery 671 of the passage 67 includes an inner surface. When light emitted by the light source L enters the passage 67, the light is blocked from penetrating the passage 67 by the inner surface. The inner surface can be a concave surface depressed toward a central axis of the passage 67 so as to block the light emitted by the light source L. Or, the inner surface can be a convex surface protruded toward a central axis of the passage 67, an outer edge of the impeller 64 is formed with a concave surface opposing the curved surface so as to block the light emitted by the light source L.

In addition, the inner surface may include one or multiple gradually shrinking surfaces and gradually expanding surfaces, as shown in FIG. 6A. Alternatively, the inner surface may include a radially and gradually shrinking curved surface and a radially and gradually expanding curved surface, both of which have different curvatures, as shown in FIG. 6B. As long as the inner periphery of the fan frame can match the curved blades, light emitted from the light source L can be blocked from penetrating the passage by the inner surface. Namely, the outer edge of the impeller 64 is parallel to the inner surface of the periphery 671 of the passage 67. The gap between the blades 66 and the housing 61 can be effectively sheltered. Thus, the fan can obstruct light from the light source L. Additionally, the curved outer edges of the blades 66 can increase the area of the blades 66, enhancing unity of the fan. Moreover, the displacement depth between the motor base 62 and the bottom of the housing 61 can be adjusted by changing the inner surface of the periphery 671 of the passage 67. Thus, the flow field of the airflow between the impeller 64 and the housing 61 can be adjusted and the noise caused by a turbulent flow field effectively reduced.

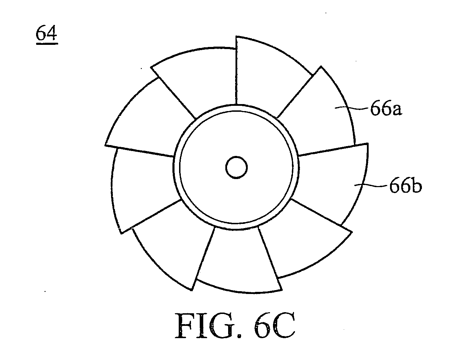

FIG. 6C is a schematic top view of an impeller of an embodiment of the invention. To effectively shelter the gap between the blades and the housing, each blade 66a of the impeller 64 overlaps an adjacent blade 66b in an axial direction of the passage. Also, each of the blades 66a and 66b has a flat, conical, curved or stepped edge.

In conclusion, the invention can overcome the drawbacks of the conventional fan in which the bottom of the motor base is coplanar with that of the fan frame. In the present fan, the motor base is raised into the housing of the fan frame to form a displacement depth, whereby providing a stable airflow. Additionally, the outward expansion portion can increase the area of air flow intake or discharge. Thus, deceleration and rectification of the airflow can be obtained, and air pressure and air flow of the fan can be increased. Furthermore, ribs with a design of varied thickness, width or cross section not only enhance the strength of the fan. The distances between the lower edges of the blades, but also reduce noise caused by adverse interaction between the ribs and the rotating blades. Moreover, the motor base can include a slope inclined radially, and the slope is linear or curved. Thus, the noise of the fan can be reduced and performance of the fan enhanced. Additionally, the housing with gradually shrinking surfaces can match the curved outer edges of the blades to shelter the gap between the housing and the blades. When the fan is applied to a light-emitting device to dissipate heat generated thereby, light leakage as in the conventional fan can be prevented.

While the invention has been described by way of example and in terms of preferred embodiment, it is to be understood that the invention is not limited thereto. To the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A fan frame, comprising:
a housing (31; 41; 51; 61) having a passage (27; 67) which forms an air outlet (211) and an air inlet (212) on both ends of the housing;
a motor base (32; 42; 52; 62) disposed in the housing; and
a plurality of ribs (33; 43) disposed between the housing and the motor base to support the motor base; wherein,
when the motor base is at the air outlet (211) or the air inlet (212), a bottom of the motor base (32; 42; 52; 62) is located on a plane (221; 222) different from that of the air outlet or the air inlet
**characterized in that** said housing further comprises an outward expansion portion (39; 49; 59; 69) at the air outlet (211) and/or air inlet (212), wherein the ribs are connected to the outward expansion portion of said housing.

2. The fan frame as claimed in claim 1, wherein a cross section of each rib (33; 43) is varied along a direction from the motor base to the housing.

3. The fan frame as claimed in claim 1 or 2, wherein a width of each rib (33; 43) is varied along the direction from the motor base to the housing, or the width of each rib gradually increases or decreases along the direction of from the motor base to the housing.

4. The fan frame as claimed in claim 3, wherein the width of each rib (33; 43) connecting to the motor base and housing is relatively greater or less than that of a central part of the rib.

5. The fan frame as claimed in any of the preceding claims, wherein a thickness of each rib (33; 43) is varied from along the direction of the motor base to the housing, or the thickness of each rib gradually increases or decreases along the direction of from the motor base to the housing.

6. The fan frame as claimed in claim 5, wherein the thickness of each rib (33; 43) connecting to the motor base and housing is relatively greater or less than that of a central part of the rib.

7. The fan frame as claimed in any of the preceding claims, said outward expansion portion (39; 49; 59; 69) at the air outlet (211) or the air inlet (212) increasing an area of air flow intake or discharge.

8. The fan frame as claimed in claim 7, wherein the outward expansion portion (39; 49; 59; 69) is formed with a lead angle, a sloped angle, a lead and sloped angle, or a curved angle.

9. The fan frame as claimed in any of the preceding claims, wherein the motor base comprises a slope inclined radially to adjust an area of air flow intake or discharge, and the slope is linear or curved.

10. A fan, comprising:
a fan frame (31; 41; 51; 61) according to any of the preceding claims and an impeller (34; 44; 54; 64), said impeller being disposed on the motor base.

11. The fan as claimed in claim 10, wherein the fan is applied to a light source (L), a periphery (671) of the passage (67) comprises an inner surface, and when light emitted by the light source enters the passage, the light is blocked from penetrating the passage by the inner surface.

12. The fan as claimed in claim 11, wherein the inner surface is a concave surface depressed toward a central axis of the passage (67) so as to block the light emitted by the light source (L).

13. The fan as claimed in claim 11, wherein the inner surface is a convex surface protruded toward a central axis of the passage (67), an outer edge of the impeller (64) is formed with a concave surface opposing the curved surface so as to block the light emitted by the light source (L).

14. The fan as claimed in claim 11, wherein the outer edge of the impeller (64) is parallel to the curved surface of the periphery (671) of the passage (67).

15. The fan as claimed in claim 11, wherein the inner surface comprises a gradually shrinking surface and a gradually expanding surface.

16. The fan as claimed in claim 11, wherein the inner surface comprises a radially and gradually shrinking curved surface and a radially and gradually expanding curved surface, both of which have different curvatures.

17. The fan as claimed in any of claims 11 to 16, wherein a maximum outer diameter of the outer edge of the impeller (64) exceeds a minimum inner diameter of the periphery (671) of the passage (67).

18. The fan as claimed in any of claims 11 to 17, wherein the impeller (64) comprises blades (66) with flat, conical, curved or stepped edges.

19. The fan as claimed in any of claims 10 to 18, wherein each blade (66) of the impeller overlaps an adjacent blade in an axial direction of the passage.

20. The fan as claimed in any of claims 10 to 19, wherein the motor base is a part of a system having a fan assembly or the motor base forms a casing sidewall of a system.

## Patentansprüche

1. Lüfterrahmen bzw. -fassung, umfassend:
ein Gehäuse (31; 41; 51; 61) mit einem Durchlass (27; 67), der auf den beiden Enden des Gehäuses einen Luftauslass (211) und einen Lufteinlass (212) ausbildet;
einen Motorsockel (32; 42; 52; 62), der in dem Gehäuse vorgesehen ist; und
eine Mehrzahl von Rippen (33; 43), die zwischen dem Gehäuse und dem Motorsockel vorgesehen sind, um den Motorsockel abzustützen; wobei
wenn sich der Motorsockel bei dem Luftauslass (211) oder dem Lufteinlass (212) befindet, ein Boden bzw. eine Unterseite des Motorsockels (32; 42; 52; 62) sich auf einer anderen Ebene (221; 222) als der Ebene des Luftauslasses oder des Lufteinlasses befindet,
**dadurch gekennzeichnet, dass** das Gehäuse außerdem einen sich auswärts erweiternden Abschnitt (39; 49; 59; 69) bei dem Luftauslass (211) und/oder dem Lufteinlass (212) umfasst, wobei die Rippen mit dem sich auswärts erweiternden Abschnitt des Gehäuses verbunden sind.

2. Lüfterrahmen nach Anspruch 1, wobei ein Querschnitt bzw. Profil von jeder Rippe (33; 43) sich entlang einer Richtung ausgehend von dem Motorsockel zu dem Gehäuse verändert.

3. Lüfterrahmen nach Anspruch 1 oder 2, wobei eine Breite von jeder Rippe (33; 43) sich entlang der Richtung von dem Motorsockel zu dem Gehäuse ändert oder die Breite von jeder Rippe entlang der Richtung ausgehend von dem Motorsockel zu dem Gehäuse allmählich zunimmt oder abnimmt.

4. Lüfterrahmen nach Anspruch 3, wobei die Breite von jeder Rippe (33; 43), die mit dem Motorsockel und dem Gehäuse verbindet, im Vergleich größer oder kleiner ist als die Breite eines zentralen Abschnitts der Rippe.

5. Lüfterrahmen nach einem der vorhergehenden Ansprüche, wobei eine Dicke von jeder Rippe (33; 43) sich entlang der Richtung ausgehend von dem Motorsockel zu dem Gehäuse ändert oder wobei die Dicke von jeder Rippe entlang der Richtung ausgehend von dem Motorsockel zu dem Gehäuse allmählich zunimmt oder abnimmt.

6. Lüfterrahmen nach Anspruch 5, wobei die Dicke von jeder Rippe (33; 43), die mit dem Motorsockel und dem Gehäuse verbindet, im Vergleich größer oder kleiner ist als die Dicke eines zentralen Abschnittes der Rippe.

7. Lüfterrahmen nach einem der vorhergehenden Ansprüche, wobei der sich auswärts erweiternde Abschnitt (39; 49; 59; 69) an dem Luftauslass (211) oder dem Lufteinlass (212) einen Querschnitt des einströmenden oder ausströmenden Luftstroms vergrößert.

8. Lüfterrahmen nach Anspruch 7, wobei der sich auswärts erweiternde Abschnit (39; 49; 59; 69) mit einem Steigungswinkel, Neigungswinkel, Steigungs- und Neigungswinkel oder einem Krümmungswinkel ausgebildet ist.

9. Lüfterrahmen nach einem der vorhergehenden Ansprüche, wobei der Motorsockel eine Neigung aufweist, die in Radialrichtung geneigt ist, um einen Querschnitt der einströmenden oder ausströmenden Luftströmung einzustellen, und wobei die Neigung linear oder gekrümmt ist.

10. Lüfter, umfassend: einen Lüfterrahmen bzw. eine Lüfterfassung (31; 41; 51; 61) nach einem der vorhergehenden Ansprüche sowie ein Flügel- bzw. Gebläserad (34; 44; 54; 64), wobei das Flügelrad auf dem Motorsockel angeordnet ist.

11. Lüfter nach Anspruch 10, bei welchem Lüfter eine Lichtquelle (L) eingesetzt wird, wobei ein Umfang (671) des Durchlasses (67) eine Innenoberfläche aufweist und dann, wenn Licht, das von der Lichtquelle emittiert wird, in den Durchlass gelangt, der Durchtritt des Lichts durch den Durchlass von der Innenoberfläche versperrt wird.

12. Lüfter nach Anspruch 11, wobei die Innenoberfläche eine konkave Oberfläche ist, die zur Mittelachse des Durchlasses (67) hin vertieft ist, um das von der Lichtquelle (L) emittierte Licht zu blocken.

13. Lüfter nach Anspruch 11, wobei die Innenoberfläche eine konvexe Oberfläche ist, die zu einer Mittelachse des Durchlasses (67) hin vorsteht, wobei eine Außenkante des Flügelrads (64) mit einer konkaven Oberfläche ausgebildet ist, die der gekrümmten Oberfläche gegenüberliegt, um so das von der Lichtquelle (L) emittierte Licht zu sperren.

14. Lüfter nach Anspruch 11, wobei die Außenkante des Flügelrads (64) parallel zu der gekrümmten Oberfläche des Umfangs (671) des Durchlasses (67) ist.

15. Lüfter nach Anspruch 11, wobei die Innenoberfläche eine sich allmählich verkleinernde Oberfläche und eine sich allmählich vergrößernde Oberfläche aufweist.

16. Lüfter nach Anspruch 11, wobei die Innenoberfläche eine radial gekrümmte und sich allmählich verkleinernde Oberfläche sowie eine radial gekrümmte und sich allmählich vergrößernde Oberfläche aufweist, die jeweils unterschiedliche Krümmungsradien haben.

17. Lüfter nach einem der Ansprüche 11 bis 16, wobei ein maximaler Außendurchmesser der Außenkante des Flügelrads (64) einen minimalen Innendurchmesser des Umfangs (671) des Durchlasses (67) übersteigt.

18. Lüfter nach einem der Ansprüche 11 bis 17, wobei das Flügelrad (64) Flügel (66) mit flachen, konischen, gekrümmten oder gestuften Kanten aufweist.

19. Lüfter nach einem der Ansprüche 10 bis 18, wobei jeder Flügel (66) des Flügelrads mit einem benachbarten Flügel in einer axialen Richtung des Durchlasses überlappt.

20. Lüfter nach einem der Ansprüche 10 bis 19, wobei der Motorsockel einen Teil eines Systems darstellt, das eine Lüfterbaugruppe umfasst, oder der Motorsockel die Seitenwand eines Gehäuses eines Systems ausbildet.

## Revendications

1. Cadre de ventilateur, comprenant :
un logement (31 ; 41 ; 51 ; 61) ayant un passage (27 ; 67) qui forme une sortie d'air (211) et une entrée d'air (212) aux deux extrémités du logement ;
une base de moteur (32 ; 42 ; 52 ; 62) disposée dans le logement ; et
une pluralité de nervures de renforcement (33 ; 43) disposées entre le logement et la base de moteur pour supporter la base de moteur ; dans lequel,
lorsque la base de moteur est au niveau de la sortie d'air (211) ou de l'entrée d'air (212), un fond de la base de moteur (32 ; 42 ; 52 ; 62) est situé sur un plan (221 ; 222) différent de celui de la sortie d'air ou de l'entrée d'air,
**caractérisé en ce que** ledit logement comprend en outre une portion d'expansion vers l'extérieur (39 ; 49 ; 59 ; 69) au niveau de la sortie d'air (211) et/ou de l'entrée d'air (212), dans lequel les nervures de renforcement sont connectées à la portion d'expansion vers l'extérieur dudit logement.

2. Cadre de ventilateur selon la revendication 1, dans lequel une coupe transversale de chaque nervure de renforcement (33 ; 43) varie le long d'une direction de la base de moteur vers le logement.

3. Cadre de ventilateur selon la revendication 1 ou 2, dans lequel une largeur de chaque nervure de renforcement (33 ; 43) varie le long de la direction de la base de moteur vers le logement, ou la largeur de chaque nervure de renforcement augmente ou diminue progressivement le long de la direction de la base de moteur vers le logement.

4. Cadre de ventilateur selon la revendication 3, dans lequel la largeur de chaque nervure de renforcement (33 ; 43) se connectant à la base de moteur et au logement est relativement supérieure ou inférieure à celle d'une partie centrale de la nervure de renforcement.

5. Cadre de ventilateur selon l'une quelconque des revendications précédentes, dans lequel une épaisseur de chaque nervure de renforcement (33 ; 43) varie le long de la direction de la base de moteur vers le logement, ou l'épaisseur de chaque nervure de renforcement augmente ou diminue progressivement le long de la direction de la base de moteur vers le logement.

6. Cadre de ventilateur selon la revendication 5, dans lequel l'épaisseur de chaque nervure de renforcement (33 ; 43) se connectant à la base de moteur et au logement est relativement supérieure ou inférieure à celle d'une partie centrale de la nervure de renforcement.

7. Cadre de ventilateur selon l'une quelconque des revendications précédentes, ladite portion d'expansion vers l'extérieur (39 ; 49 ; 59 ; 69) au niveau de la sortie d'air (211) ou de l'entrée d'air (212) augmentant une zone de capture ou d'évacuation de flux d'air.

8. Cadre de ventilateur selon la revendication 7, dans lequel la portion d'expansion vers l'extérieur (39 ; 49 ; 59 ; 69) est formée d'un angle de filet, d'un angle en pente, d'un angle de filet et en pente ou d'un angle courbé.

9. Cadre de ventilateur selon l'une quelconque des revendications précédentes, dans lequel la base de moteur comprend une pente inclinée radialement pour ajuster une zone de capture ou d'évacuation de flux d'air et la pente est linéaire ou courbée.

10. Ventilateur, comprenant :
un cadre de ventilateur (31 ; 41 ; 51 ; 61) selon l'une quelconque des revendications précédentes et une roue de ventilateur (34 ; 44 ; 54 ; 64), ladite roue de ventilateur étant disposée sur la base de moteur.

11. Ventilateur selon la revendication 10, dans lequel le ventilateur est appliqué à une source lumineuse (L), une périphérie (671) du passage (67) comprend une surface interne, et lorsque de la lumière émise par la source lumineuse pénètre dans le passage, la lumière est empêchée de pénétrer dans le passage par la surface interne.

12. Ventilateur selon la revendication 11, dans lequel la surface interne est une surface concave enfoncée vers un axe central du passage (67) de manière à bloquer la lumière émise par la source lumineuse (L).

13. Ventilateur selon la revendication 11, dans lequel la surface interne est une surface convexe faisant saillie vers un axe central du passage (67), un bord externe de la roue de ventilateur (64) est formé avec une surface concave faisant face à la surface courbée de manière à bloquer la lumière émise par la source lumineuse (L).

14. Ventilateur selon la revendication 11, dans lequel le bord externe de la roue de ventilateur (64) est parallèle à la surface courbée de la périphérie (671) du passage (67).

15. Ventilateur selon la revendication 11, dans lequel la surface interne comprend une surface se rétrécissant progressivement et une surface subissant une expansion progressive.

16. Ventilateur selon la revendication 11, dans lequel la surface interne comprend une surface courbée se rétrécissant radialement et progressivement et une surface courbée subissant une expansion radiale et progressive, toutes deux ayant différentes courbures.

17. Ventilateur selon l'une quelconque des revendications 11 à 16, dans lequel un diamètre externe maximal du bord externe de la roue de ventilateur (64) dépasse un diamètre interne minimal de la périphérie (671) du passage (67).

18. Ventilateur selon l'une quelconque des revendications 11 à 17, dans lequel la roue de ventilateur (64) comprend des pales (66) avec des bords plats, coniques, courbés ou étagés.

19. Ventilateur selon l'une quelconque des revendications 10 à 18, dans lequel chaque pale (66) de la roue de ventilateur chevauche une pale adjacente dans une direction axiale du passage.

20. Ventilateur selon l'une quelconque des revendications 10 à 19, dans lequel la base de moteur fait partie d'un système ayant un ensemble de ventilateur ou la base de moteur forme une paroi latérale de boîtier d'un système.
